# EUROPEAN PATENT APPLICATION

(11) **EP 3 453 788 A1**
(43) Date of publication of application: **13.03.2019**
(21) Application number: 18192239.4
(22) Date of filing: 03.09.2018
(51) Int. Cl.: C25D 5/56, C23C 14/20, C23C 28/02, C23C 18/30

(54) **METHOD FOR MANUFACTURING METAL-COATED RESIN PRODUCT, AND METAL-COATED RESIN SUBSTRATE**

(30) Priority: 07.09.2017 JP 2017172545
(71) Applicant: Kojima Industries Corporation, Toyota-shi, Aichi 471-0875 (JP)
(72) Inventor: IMAI, Tatsuya, Toyota-shi, Aichi (JP); NAKAMURA, Yukihiro, Toyota-shi, Aichi (JP)
(74) Representative: Wunderlich & Heim Patentanwälte Partnerschaftsgesellschaft mbB

(57) **Abstract**

A method for manufacturing a metal-coated resin product (1) according to the present embodiment includes: a pretreatment step of forming an alloy layer (16) constituted by an alloy containing Pd and a metal having a lower ionization tendency than hydrogen on a surface of a resin substrate (14) having at least one of a COO group and a CN group by a physical vapor deposition method or a chemical vapor deposition method, thereby making Pd in the alloy layer (16) coordinate-bonded to at least one of the COO group and the CN group; and a step of forming a metal plating layer (12) on the alloy layer (16) by an electroplating method.

## Description

### TECHNICAL FIELD

The present invention relates to a method for manufacturing a metal-coated resin product, and to a metal-coated resin substrate.

### BACKGROUND

Conventionally, a resin product in which a metal plating layer is formed on a surface of a resin substrate has been known. This resin product is lightweight, has excellent moldability and processability, and does not require rustproofing, and therefore has been widely used to manufacture various products, covering materials of articles, parts, and the like such as automotive interior parts, furniture, building materials, household electric appliances, and portable electronic devices.

As a conventionally general method for forming a metal plating layer, there is known, for example, a method for subjecting a resin substrate to a pretreatment step such as an etching step, an etching neutralization step, a catalyst applying step, or an electroless plating step to impart conductivity to a surface of the resin substrate, and then applying electroplating such as copper sulfate plating, semi-gloss nickel plating, gloss nickel plating, or chromium plating onto the surface of the resin substrate.

Incidentally, in the etching step in the pretreatment step, high concentration of chromic acid (hexavalent chromium) is used even at present. However, in recent years, in order to eliminate the etching step using chromic acid (hexavalent chromium), various techniques have been proposed in the pretreatment step of electroplating from a viewpoint of environment including a working environment.

Examples of a pretreatment step of electroplating not including the etching step using chromic acid include a technique of forming a metal layer on a surface of a resin substrate by physical vapor deposition or chemical vapor deposition.

For example, JP 2008-31555 A discloses a technique of forming a metal layer on a surface of a resin substrate by sputtering and then applying electroplating onto the metal layer formed on the resin substrate.

However, in the pretreatment technique in which a metal layer is formed on a surface of a resin substrate by physical vapor deposition or chemical vapor deposition, adhesion between the resin substrate and the metal layer is low, which is disadvantageous. In addition, some metal species constituting the metal layer formed on the surface of the resin substrate reduce a plating rate of electroplating applied onto the metal layer, which is also disadvantageous.

Therefore, an object of the present invention is to provide a method for manufacturing a metal-coated resin product, and a metal-coated resin substrate, improving adhesion between a resin substrate and a metal layer formed on a surface of the resin substrate and suppressing a reduction in plating rate of electroplating applied onto the metal layer.

### SUMMARY

A method for manufacturing a metal-coated resin product according to the present invention is characterized by including: a pretreatment step of forming an alloy layer constituted by an alloy containing Pd and a metal having a lower ionization tendency than hydrogen on a surface of a resin substrate having at least one of a COO group and a CN group by a physical vapor deposition method or a chemical vapor deposition method, and thereby making Pd in the alloy layer coordinate-bonded to at least one of the COO group and the CN group; and a step of forming a metal plating layer on the alloy layer by an electroplating method.

In the method for manufacturing a metal-coated resin product, a sputtering method as the physical vapor deposition method is preferably used in the pretreatment step.

In the method for manufacturing a metal-coated resin product, the metal having a lower ionization tendency than hydrogen is preferably at least one selected from Au, Ag, and Cu.

In the method for manufacturing a metal-coated resin product, the resin substrate is preferably at least one selected from a polycarbonate resin, an acrylic resin, an acrylonitrile-butadiene-styrene resin, and an acrylonitrile-styrene-acrylate resin.

A metal-coated resin substrate according to the present invention includes a resin substrate having at least one of a COO group and a CN group, and an alloy layer disposed on the resin substrate, and is characterized in that the alloy layer is constituted by an alloy containing Pd and a metal having a lower ionization tendency than hydrogen, and that Pd in the alloy layer is coordinate-bonded to at least one of the COO group and the CN group.

In the metal-coated resin substrate, the metal having a lower ionization tendency than hydrogen is preferably at least one selected from Au, Ag, and Cu.

In the metal-coated resin substrate, the resin substrate is preferably at least one selected from a polycarbonate resin, an acrylic resin, an acrylonitrile-butadiene-styrene resin, and an acrylonitrile-styrene-acrylate resin.

The present invention can provide a method for manufacturing a metal-coated resin product, and a metal-coated resin substrate, improving adhesion between a resin substrate and a metal layer formed on a surface of the resin substrate and suppressing a reduction in plating rate of electroplating applied onto the metal layer.

### BRIEF DESCRIPTION OF THE DRAWINGS

Embodiment(s) of the present disclosure will be described by reference to the following figures, wherein:
FIG. 1 is a schematic cross-sectional view of a metal-coated resin product including a metal-coated resin substrate according to the present embodiment;
FIG. 2 is a schematic view illustrating a sputtering apparatus for forming an alloy layer on a surface of a resin substrate by a sputtering method;
FIG. 3 is a graph illustrating results of XPS analysis of a Pd3d spectrum at an interface between a resin substrate and an alloy layer in each of Examples 1 and 2 and Comparative Example 1; and
FIG. 4 is a graph illustrating results of XPS analysis of an Ag3d spectrum at an interface between a resin substrate and an alloy layer in each of Examples 1 and 2 and Comparative Example 1.

### DESCRIPTION OF EMBODIMENTS

Hereinafter, a mode for performing the present invention (hereinafter, referred to as "the present embodiment") will be described. The present embodiment is an example of performing the present invention, and the present invention is not limited to the present embodiment.

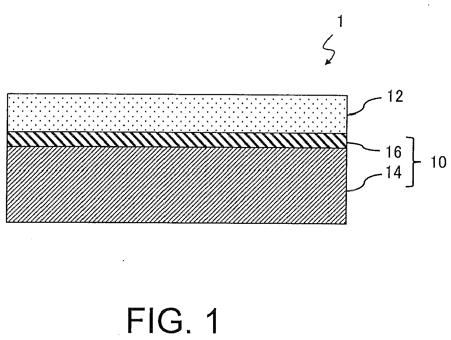

FIG. 1 is a schematic cross-sectional view of a metal-coated resin product including a metal-coated resin substrate according to the present embodiment. A metal-coated resin product 1 illustrated in FIG. 1 includes a metal-coated resin substrate 10 according to the present embodiment and a metal plating layer 12. The metal-coated resin substrate 10 includes a resin substrate 14, and an alloy layer 16 disposed on a surface of the resin substrate 14. In the alloy layer 16, a surface opposite a surface in contact with the resin substrate 14 is a surface on which the metal plating layer 12 is formed, and the metal plating layer 12 is formed on this surface.

The metal plating layer 12 is formed on the alloy layer 16 of the metal-coated resin substrate 10 by an electroplating method. Examples of the metal plating layer 12 include a metal plating layer formed by laminating a copper sulfate plating layer, a semi-gloss nickel plating layer, a gloss nickel plating layer, and a chromium plating layer in this order on the alloy layer 16 of the metal-coated resin substrate 10. However, the metal plating layer 12 is not limited thereto, and may be appropriately determined according to use of the metal-coated resin product 1, required characteristics thereof, and the like.

The resin substrate 14 constituting the metal-coated resin substrate 10 is the resin substrate 14 having at least one of a COO group and a CN group, and examples thereof include a polycarbonate resin, an acrylic resin, an acrylonitrile-butadiene-styrene resin (ABS resin), and an acrylonitrile-styrene-acrylate resin (ASA resin). These resins may be used singly or in combination of two or more kinds thereof.

No particular limitation is imposed on the thickness of the resin substrate 14 so long as the thickness is appropriately determined according to use of the metal-coated resin product 1, required characteristics thereof, and the like. However, for example, the thickness of the resin substrate 14 is about 2 to 7 mm.

The resin substrate 14 is obtained, for example, by molding a resin having at least one of a COO group and a CN group. No particular limitation is imposed on a method for molding the resin, and various molding methods such as injection molding, compression molding, extrusion molding, and blow molding are adopted.

The alloy layer 16 constituting the metal-coated resin substrate 10 is constituted by an alloy containing Pd and a metal having a lower ionization tendency than hydrogen, and Pd is coordinate-bonded to a COO group or a CN group in the resin substrate 14. Whether Pd is coordinate-bonded to a COO group or a CN group can be confirmed by X-ray photoelectron spectroscopy (XPS) (specifically, refer to the section of Examples).

Examples of the metal having a lower ionization tendency than hydrogen include Sb, Bi, Cu, Hg, Ag, Ir, Pt, and Au. These metals may be used singly or in combination of two or more kinds thereof. Incidentally, Pd is also a metal having a lower ionization tendency than hydrogen, but it is naturally understood that Pd is not included because the metal having a lower ionization tendency than hydrogen here is an alloy with Pd.

The alloy layer 16 is formed on a surface of the resin substrate 14 by a physical vapor deposition method or a chemical vapor deposition method as described below. Here, Pd is shifted to acidity, and a COO group and a CN group are shifted to basicity. Therefore, by collision of a Pd atom released from a target with the resin substrate 14 by a physical vapor deposition method or a chemical vapor deposition method, it is estimated that the Pd atom is coordinate-bonded to a COO group or a CN group in the resin substrate 14.

As described above, in the metal-coated resin substrate 10 according to the present embodiment, Pd in the alloy layer 16 is coordinate-bonded to a COO group or a CN group in the resin substrate 14. Therefore, as compared with a case where an alloy layer simply physically adheres to a surface of a resin substrate (that is, a case where metal species in an alloy layer are not chemically bonded to a resin substrate), adhesion between the resin substrate and the alloy layer formed on a surface of the resin substrate is improved. By using the metal-coated resin substrate 10 according to the present embodiment, for example, peeling of the alloy layer 16 from the substrate 14 is suppressed by a plating solution used for forming the metal plating layer 12 on the alloy layer 16 by an electroplating method, and furthermore the metal plating layer 12 can be stably formed on the alloy layer 16.

In addition, the alloy layer 16 constituted by an alloy containing Pd and a metal having a lower ionization tendency than hydrogen has higher electrochemical stability than an alloy layer containing no metal having a lower ionization tendency than hydrogen. Therefore, by using the metal-coated resin substrate 10 according to the present embodiment, for example, deterioration of the alloy layer 16 is suppressed by a plating solution used for forming the metal plating layer 12 on the alloy layer 16 by an electroplating method, thereby suppressing a reduction in plating rate of electroplating applied onto the alloy layer 16.

The metal having a lower ionization tendency than hydrogen is preferably at least one selected from Au, Ag, and Cu from a viewpoint of further suppressing a reduction in plating rate of electroplating or the like. By inclusion of at least one of Au, Ag, and Cu in the alloy layer 16, as compared with a case where the alloy layer 16 contains no Au, Ag, or Cu, conductivity of the alloy layer 16 is improved, and therefore a reduction in plating rate of electroplating is further suppressed.

In a preferable composition ratio of the alloy constituting the alloy layer 16, the content of Pd is 3% by atom or more and 15% by atom or less, and the content of the metal having a lower ionization tendency than hydrogen is 85% by atom or more and 97% by atom or less. In a more preferable composition ratio of the alloy constituting the alloy layer 16, the content of Pd is 5% by atom or more and 10% by atom or less, and the content of the metal having a lower ionization tendency than hydrogen is 90% by atom or more and 95% by atom or less. In the composition ratio of the alloy, if the content of Pd is less than 3% by atom and the content of the metal having a lower ionization tendency than hydrogen is more than 97% by atom, as compared with a case where the composition ratio satisfies the above ranges, for example, adhesion between the alloy layer 16 and the resin substrate 14 may be reduced. In addition, in the composition ratio of the alloy, if the content of Pd is more than 15% by atom and the content of the metal having a lower ionization tendency than hydrogen is less than 85% by atom, as compared with a case where the composition ratio satisfies the above ranges, for example, conductivity of the alloy layer 16 may be reduced, and an effect of suppressing a reduction in plating rate of electroplating may be reduced.

In addition to Pd and the metal having a lower ionization tendency than hydrogen, the alloy layer 16 may contain a metal having a higher ionization tendency than hydrogen, so long as the effect of the present invention is not impaired.

No particular limitation is imposed on the thickness of the alloy layer 16, so long as the thickness is appropriately determined according to use of the metal-coated resin product 1, required characteristics thereof, and the like. However, for example, the thickness of the alloy layer 16 is 0.001 µm or more and 1 µm or less.

A method for manufacturing the metal-coated resin product 1 according to the present embodiment includes: a pretreatment step of forming the alloy layer 16 constituted by an alloy containing Pd and a metal having a lower ionization tendency than hydrogen on a surface of the resin substrate 14 having at least one of a COO group and a CN group by a physical vapor deposition method or a chemical vapor deposition method, thereby making Pd in the alloy layer 16 coordinate-bonded to at least one of the COO group and the CN group; and a step of forming the metal plating layer 12 on the alloy layer 16 by an electroplating method.

Examples of the physical vapor deposition method (PVD method) in the pretreatment step include a vacuum vapor deposition method, a sputtering method, and an ion plating method. Examples of the chemical vapor deposition method (CVD method) in the pretreatment step include a thermal CVD method, a plasma CVD method, and a photo CVD method. Among these methods, the sputtering method is preferable, for example, in view of easy formation of an alloy containing Pd and a metal having a lower ionization tendency than hydrogen on a surface of the resin substrate 14.

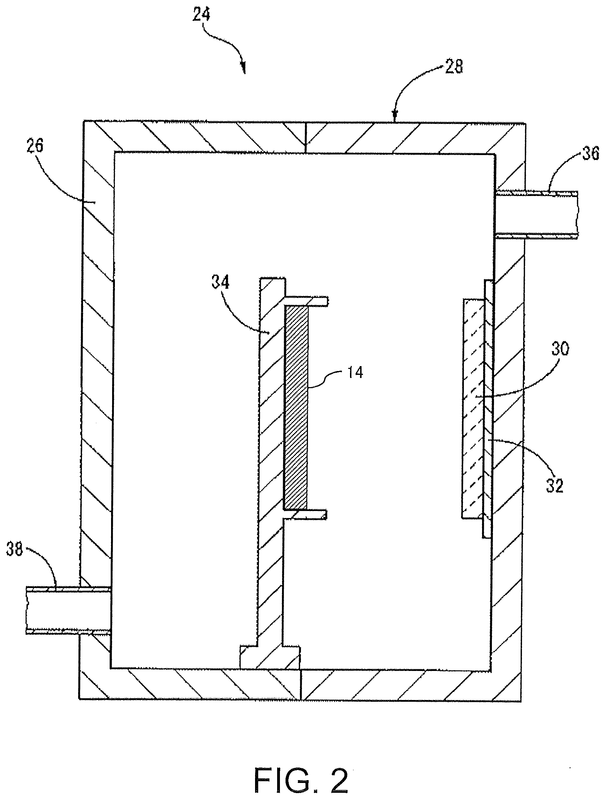

FIG. 2 is a schematic view illustrating a sputtering apparatus for forming an alloy layer on a surface of a resin substrate by a sputtering method. A sputtering apparatus 24 illustrated in FIG. 2 has a conventionally known structure including a vacuum chamber 28. The vacuum chamber 28 has a peripheral wall portion 26. A target 30 is replaceably attached to one circumferential position on an inner peripheral surface of the peripheral wall portion 26 via a sputtering cathode 32. Furthermore, a supporting apparatus 34 for ejectably supporting the resin substrate 14 stands on a bottom wall portion of the vacuum chamber 28. Furthermore, a sputtering anode (not illustrated) is disposed in the supporting apparatus 34. A voltage is applied between the sputtering cathode 32 located on an inner peripheral surface of the peripheral wall portion 26 and the sputtering anode disposed in the supporting apparatus 34 by a power supply apparatus (not illustrated).

A gas introduction pipe 36 and a gas discharge pipe 38 are connected to the peripheral wall portion 26 of the vacuum chamber 28 at positions different from each other in a circumferential direction thereof while being open into the vacuum chamber 28 at one end of each of the gas introduction pipe 36 and the gas discharge pipe 38. The gas introduction pipe 36 is connected to a gas supply apparatus (not illustrated) for supplying a reaction gas such as an inert gas at an end opposite to a side of the vacuum chamber 28. Meanwhile, the gas discharge pipe 38 is connected to a vacuum pump (not illustrated) on an end side opposite to the side of the vacuum chamber 28.

When an alloy layer is formed on a surface of the resin substrate 14 using the sputtering apparatus 24, first, as illustrated in FIG. 2, the target 30 is attached onto an inner peripheral surface of the peripheral wall portion 26 via the sputtering cathode 32. As the target 30, an alloy material containing Pd and a metal having a lower ionization tendency than hydrogen is used. The resin substrate 14 is set in the supporting apparatus 34 in the vacuum chamber 28, and a surface of the resin substrate 14 is caused to face the target 30. The resin substrate 14 is a resin substrate having at least one of a COO group and a CN group; for example, a substrate obtained by subjecting a polycarbonate resin or the like to injection molding.

Next, a vacuum pump (not illustrated) connected to the gas discharge pipe 38 is operated to bring an inside of the vacuum chamber 28 into a vacuum state. A pressure in the vacuum chamber 28 at this time is, for example, about 1 to 5 Pa. Thereafter, for example, a reaction gas containing an inert gas such as an argon gas is introduced into the vacuum chamber 28 from a gas supply apparatus (not illustrated) through the gas introduction pipe 36. Then, when the vacuum chamber 28 is filled with the reaction gas, a predetermined voltage is applied between the sputtering cathode 32 and a sputtering anode (not illustrated) by operating a power supply apparatus (not illustrated). As a result, plasma is generated in a space between the target 30 and the resin substrate 14 in the vacuum chamber 28 to cause a sputtering phenomenon on a discharge surface (a surface facing the resin substrate 14) of the target 30. Atoms of Pd and a metal having a lower ionization tendency than hydrogen are released from the target 30, and these atoms are caused to collide with a surface of the resin substrate 14 to adhere thereto. In this way, an alloy layer constituted by an alloy containing Pd and a metal having a lower ionization tendency than hydrogen is formed on the surface of the resin substrate 14, and Pd in the alloy layer is coordinate-bonded to a COO group or a CN group in the resin substrate 14.

In the electroplating step after the pretreatment step, the only requirement is to perform various kinds of electroplating according to use of the metal-coated resin product or the like. For example, in a case where a metal-coated resin product is used as an automobile exterior part, each electroplating is performed in the order of copper sulfate plating, semi-gloss nickel plating, gloss nickel plating, and chromium plating as electroplating on an alloy layer of a metal-coated resin substrate. Specifically, the metal-coated resin substrate is sequentially immersed in various electroplating baths for electroplating. Each electroplating bath is filled with a plating solution corresponding to each electroplating step, and includes an anode electrode. By applying an anode voltage to the anode electrode and applying a cathode voltage to the metal-coated resin substrate, a metal component dissolved in the plating solution is deposited on an alloy layer of the metal-coated resin substrate to form a metal plating layer on the alloy layer. These kinds of electroplating are examples, and electroplating is not limited to those described above.

According to the method for manufacturing a metal-coated resin product according to the present embodiment, by forming an alloy layer constituted by an alloy containing Pd and a metal having a lower ionization tendency than hydrogen on a surface of a resin substrate having at least one of a COO group and a CN group by a physical vapor deposition method or a chemical vapor deposition method, Pd in the alloy layer is coordinate-bonded to the COO group or the CN group in the resin substrate, and therefore adhesion between the alloy layer and the resin substrate can be improved. As a result, for example, peeling of the alloy layer from the resin substrate is suppressed by a plating solution used for forming the metal plating layer by an electroplating method. Furthermore, the metal plating layer can be stably formed on the alloy layer. In addition, the alloy layer containing Pd and a metal having a lower ionization tendency than hydrogen is electrochemically stable. Therefore, deterioration of the alloy layer is suppressed, for example, by the plating solution used for forming the metal plating layer on the alloy layer. This suppresses a reduction in plating rate of electroplating performed for forming the metal plating layer on the alloy layer.

### EXAMPLES

Hereinafter, embodiments of the present invention will be described more specifically based on Examples. Note that the present invention is not limited to the following Examples.

### (Example 1)

As a resin substrate, there was used a copolymer type resin substrate of a polycarbonate resin and an acrylonitrile-styrene-acrylate resin (ASA resin) (hereinafter, referred to as a PC-ASA resin substrate). The PC-ASA resin substrate is a resin substrate containing a COO group and a CN group.

An alloy layer constituted by a Pd-Ag alloy was formed on a surface of the PC-ASA resin substrate by a sputtering method to obtain a metal-coated resin substrate. Specifically, first, a target of a Pd-Ag alloy was disposed in a sputtering apparatus. In a composition ratio of the Pd-Ag alloy used as the target, the content of Pd was 7% by mass and the content of Ag was 93% by mass. Next, a PC-ASA resin substrate was disposed in the sputtering apparatus such that a surface of the PC-ASA resin substrate faced the target. Then, the inside of a vacuum chamber of the sputtering apparatus was evacuated to 8.0 × 10⁻³ Pa. Thereafter, an argon gas was introduced thereinto to set the total pressure to about 2.0 × 10⁻² Pa, and electric power of 6 kW was applied thereto to form an alloy layer constituted by a Pd-Ag alloy on a surface of the resin substrate to obtain a metal-coated resin substrate. The alloy layer had a film thickness of 40 nm.

In addition, chemical structure analysis of an interface between the PC-ASA resin substrate and the alloy layer in the obtained metal-coated resin substrate was performed by XPS.

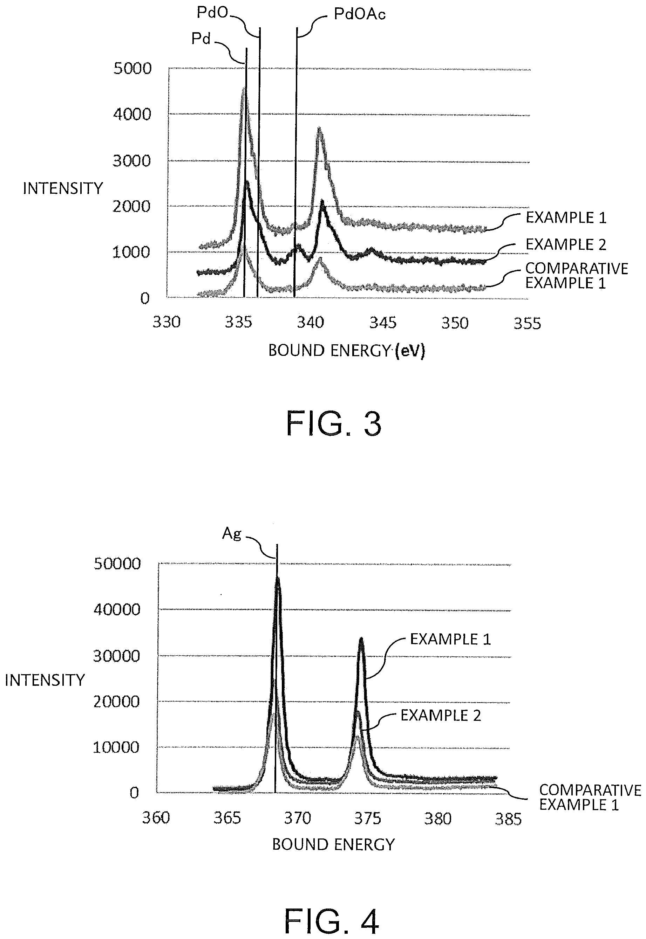

FIG. 3 illustrates results of XPS analysis of a Pd3d spectrum at the interface between the PC-ASA resin substrate and the alloy layer. As illustrated in FIG. 3, in the Pd3d spectrum, in addition to a peak derived from metal Pd (around 335.2 eV), a peak derived from PdO (around 336.3 eV) and a peak derived from PdOAc (= PdOOCCH₃) (around 339 eV) were observed. This indicates that Pd in the alloy layer is coordinate-bonded to a COO group of the PC-ASA resin substrate.

FIG. 4 illustrates results of XPS analysis of an Ag3d spectrum at the interface between the PC-ASA resin substrate and the alloy layer. As illustrated in FIG. 4, only a peak derived from metal Ag (around 368 eV and around 375 eV) was observed. This result confirms that Ag in the alloy layer was present in a state of metal Ag and was not coordinate-bonded to a COO group in the PC-ASA resin substrate. Incidentally, although not illustrated, it was also confirmed that Ag in the alloy layer was not coordinate-bonded to a CN group in the PC-ASA resin substrate.

### (Example 2)

A metal-coated resin substrate was manufactured in a similar manner to Example 1 except that the PC-ASA resin substrate was replaced with a polycarbonate resin substrate (a resin substrate containing a COO group, hereinafter, referred to as a PC resin substrate). Then, chemical structure analysis of an interface between the PC resin substrate and the alloy layer in the obtained metal-coated resin substrate was performed by XPS.

FIGS. 3 and 4 illustrate results of XPS analysis of a Pd3d spectrum and an Ag3d spectrum at the interface between the PC resin substrate and the alloy layer, respectively. As illustrated in FIG. 3, the Pd3d spectrum in Example 2 indicated a waveform similar to that in Example 1. That is, this indicates that Pd in the alloy layer in Example 2 is coordinate-bonded to a COO group in the PC resin substrate. Furthermore, as illustrated in FIG. 4, the Ag3d spectrum in Example 2 also indicated a waveform similar to that in Example 1. That is, it was confirmed that Ag in the alloy layer was present in a state of metal Ag and was not coordinate-bonded to a COO group of the PC resin substrate.

### (Comparative Example 1)

A metal-coated resin substrate was manufactured in a similar manner to Example 1 except that the PC-ASA resin substrate was replaced with a polypropylene resin substrate (a resin substrate not containing a COO group or a CN group, hereinafter, referred to as a PP resin substrate). Then, chemical structure analysis of an interface between the PP resin substrate and the alloy layer in the obtained metal-coated resin substrate was performed by XPS.

FIG. 3 illustrates results of XPS analysis of a Pd3d spectrum at the interface between the PP resin substrate and the alloy layer. As illustrated in FIG. 3, in the Pd3d spectrum in Comparative Example 1, only a peak derived from metal Pd (around 335.2 eV) was observed. This indicates that Pd in the alloy layer is present in a state of metal Pd, and is not coordinate-bonded to the resin substrate.

FIG. 4 illustrates results of XPS analysis of an Ag3d spectrum at the interface between the PP resin substrate and the alloy layer. As illustrated in FIG. 4, in the Ag3d spectrum in Comparative Example 1, only a peak derived from metal Ag (around 368 eV and around 375 eV) was observed. This indicates that Ag in the alloy layer is present in a state of metal Ag, and is not coordinate-bonded to the resin substrate.

### (Comparative Example 2)

A metal-coated resin substrate was manufactured in a similar manner to Example 1 except that the target of the Pd-Ag alloy was changed to a target of Ti to form a metal layer constituted by Ti on the PC-ASA resin substrate.

### <Adhesion Test>

An adhesion test of a metal-coated resin substrate in each of Examples and Comparative Examples was performed based on JIS K 5600-5-6, and adhesion of an alloy layer (metal layer) was evaluated. As a result, an evaluation result for a sample having excellent adhesion was indicated by ○, an evaluation result for a sample having slightly poor adhesion (slight peeling) was indicated by Δ, and an evaluation result for a sample with significant peeling was indicated by x.

In both Comparative Example 1 in which an alloy layer constituted by an alloy containing Pd and a metal having a lower ionization tendency than hydrogen was formed on a surface of a resin substrate not containing a COO group or a CN group by physical vapor deposition, and Comparative Example 2 in which a metal layer containing no Pd was formed on a surface of a resin substrate containing at least one of a COO group and a CN group by physical vapor deposition, evaluation of adhesion was ×. Meanwhile, in both Examples 1 and 2 in which an alloy layer constituted by an alloy containing Pd and a metal having a lower ionization tendency than hydrogen was formed on a surface of a resin substrate containing at least one of a COO group and a CN group by physical vapor deposition, and Pd in the alloy layer was coordinate-bonded to the COO group or the CN group, evaluation of adhesion was ○, and adhesion was able to be improved as compared with Comparative Examples 1 and 2.

### <Copper sulfate Plating>

Copper sulfate plating was applied onto the alloy layer (metal layer) of the metal-coated resin substrate in each of Example 1 and Comparative Example 2 by an electroplating method to manufacture a metal-coated resin product. In this electroplating method, a copper sulfate plating solution (200 g/L copper sulfate, 50 g/L sulfuric acid, 70 mg/L chlorine ion, solvent: pure water, Topolchina 2000MU(5 ml/L) and Topolchina 2000A (0.5 ml/L) manufactured by Okuno Pharmaceutical Industry) was used, a current was 1.4 mA, and plating time was 20 minutes.

An average thickness of the copper sulfate plating layer formed on the alloy layer of the metal-coated resin substrate in Example 1 was 10 µm, whereas an average thickness of the copper sulfate plating layer formed on the metal layer of the metal-coated resin substrate in Comparative Example 2 was 1.3 µm. That is, in Example 1, a metal plating layer having a thickness of about 8 times that in Comparative Example 2 was formed in the same plating time. Therefore, by forming an alloy layer constituted by an alloy containing Pd and a metal having a lower ionization tendency than hydrogen on a surface of a resin substrate containing at least one of a COO group and a CN group by physical vapor deposition, and making Pd in the alloy layer coordinate-bonded to the COO group or the CN group, a reduction in plating rate of electroplating applied onto the alloy layer was suppressed.

### REFERENCE SIGNS LIST

- 1: Metal-coated resin product
- 10: Metal-coated resin substrate
- 12: Metal plating layer
- 14: Resin substrate
- 16: Alloy layer
- 24: Sputtering apparatus
- 26: Peripheral wall portion
- 28: Vacuum chamber
- 30: Target
- 32: Sputtering cathode
- 34: Supporting apparatus
- 36: Gas introduction pipe
- 38: Gas discharge pipe.

## Claims

1. A method for manufacturing a metal-coated resin product (1), **characterized by** comprising:
a pretreatment step of forming an alloy layer (16) constituted by an alloy containing Pd and a metal having a lower ionization tendency than hydrogen on a surface of a resin substrate (14) having at least one of a COO group and a CN group by a physical vapor deposition method or a chemical vapor deposition method, thereby making Pd in the alloy layer (16) coordinate-bonded to at least one of the COO group and the CN group; and
a step of forming a metal plating layer (12) on the alloy layer (16) by an electroplating method.

2. The method for manufacturing a metal-coated resin product (1) according to claim 1, **characterized in that** a sputtering method as the physical vapor deposition method is used in the pretreatment step.

3. The method for manufacturing a metal-coated resin product (1) according to claim 1 or 2, **characterized in that** the metal having a lower ionization tendency than hydrogen is at least one selected from Au, Ag, and Cu.

4. The method for manufacturing a metal-coated resin product (1) according to any one of claims 1 to 3, **characterized in that** the resin substrate (14) is at least one selected from a polycarbonate resin, an acrylic resin, an acrylonitrile-butadiene-styrene resin, and an acrylonitrile-styrene-acrylate resin.

5. A metal-coated resin substrate comprising:
a resin substrate (14) having at least one of a COO group and a CN group; and
an alloy layer (16) disposed on the resin substrate (14), **characterized in that**
the alloy layer is constituted by an alloy (16) containing Pd and a metal having a lower ionization tendency than hydrogen, and
Pd in the alloy layer (16) is coordinate-bonded to at least one of the COO group and the CN group.

6. The metal-coated resin substrate (10) according to claim 5, **characterized in that** the metal having a lower ionization tendency than hydrogen is at least one selected from Au, Ag, and Cu.

7. The metal-coated resin substrate (10) according to claim 5 or 6, **characterized in that** the resin substrate (14) is at least one selected from a polycarbonate resin, an acrylic resin, an acrylonitrile-butadiene-styrene resin, and an acrylonitrile-styrene-acrylate resin.
